(19) Europäisches Patentamt
European Patent Office
Office européen des brevets

(11) EP 2 738 548 A1

(12) **DEMANDE DE BREVET EUROPEEN**

(43) Date de publication:
**04.06.2014 Bulletin 2014/23**

(51) Int Cl.:
**G01N 27/04** *(2006.01)*  **G01R 27/20** *(2006.01)*
**G01N 33/24** *(2006.01)*

(21) Numéro de dépôt: **12306502.1**

(22) Date de dépôt: **30.11.2012**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(71) Demandeur: **GRDF**
**75009 Paris (FR)**

(72) Inventeur: **La désignation de l'inventeur n'a pas encore été déposée**

(74) Mandataire: **Hamann, Jean-Christophe**
**Schmit-Chrétien**
**25, allée Cavalière**
**44500 La Baule (FR)**

(54) **Procédé et dispositif pour la mesure d'une résistance de terre et la résistivité d'un sol**

(57) L'invention concerne un dispositif (200) pour la mesure d'une résistance de sol (100), lequel dispositif consiste en :

a. une électrode (221), dite piquet, apte à être insérée dans le sol ;

b. un moyen (222) de connexion électrique à une structure (210) enterrée, notamment une canalisation ;

c. un circuit (230) électrique de liaison, d'impédance (241) connue, reliant l'électrode (221) piquet et le moyen (222) de connexion ;

d. des moyens (240) de commutation aptes à ouvrir et à fermer ledit circuit (230) électrique de liaison ;

e. un moyen (233), dit ampèremètre, apte à mesurer le courant dans le circuit électrique de liaison ;

f. un moyen (232), dit voltmètre, apte à mesurer la différence de potentiel entre l'électrode (221) piquet et le moyen (222) de connexion électrique

g. un ensemble (250) d'acquisition et de traitement comprenant des moyens de pilotage des moyens (240) de commutation.

Fig. 2

## Description

L'invention concerne un procédé et un dispositif pour la mesure d'une résistance de terre ainsi que la résistivité d'un sol. L'invention est plus particulièrement, mais non exclusivement, adaptée aux mesures visant à contrôler l'efficacité et la conformité d'une prise de terre d'une installation électrique, aux mesures préalables à la mise en oeuvre d'une protection cathodique d'un moyen enterré, ou encore, aux mesures visant à déterminer le meilleur emplacement pour l'installation d'une prise de terre.

Selon l'art antérieur de telles mesures mettent en oeuvre un moyen dit « ohmmètre de terre » ou « telluromètre », lequel moyen permet l'injection d'un courant dans le sol, et la mesure d'une résistance entre deux points de mesure traversés par ledit courant. D'un point de vue pratique, l'injection de courant ainsi que la mesure de résistance sont réalisées par l'intermédiaire d'éléments conducteurs, tels que des piquets, enfouis dans le sol.

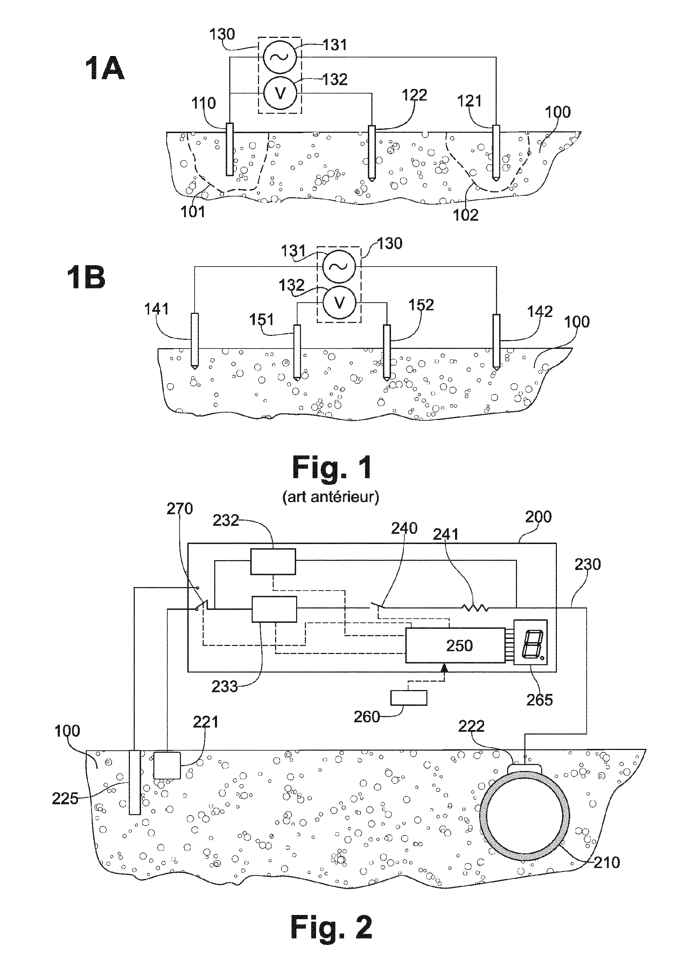

La figure 1 relative à l'art antérieur illustre le principe d'une méthode de mesure de la résistance d'une prise de terre, méthode dont dérivent les différentes variante de la méthode dite « des 62 % ». La méthode consiste à imposer, au moyen d'un générateur (131), la circulation d'un courant électrique entre la prise de terre (110) et un piquet (121), dit d'injection de courant, planté dans le sol (100), la prise de terre (110) étant déconnectée de l'installation électrique dont elle assure la protection. Un deuxième piquet (122), dit prise de potentiel, est planté dans le sol à une distance teklle de la prise de terre (110) et du piquet (121) d'injection de courant, que la dite prise de potentiel se trouve en dehors des zones (101, 102) d'influence de ladite prise de terre (110) et dudit piquet (121) injection de courant. Un voltmètre (132) mesure la tension $U$ entre la prise (122) de potentiel, laquelle se trouve à un potentiel nul, et la prise de terre (110) alors qu'un courant $I$ est injecté dans le sol par l'intermédiaire du piquet (121) d'injection de courant. La résistance $R$ de la prise de terre est donné par la loi d'ohm : $R = U/I$. L'ensemble (130) comprenant le voltmètre (132) et le générateur (131) de courant constitue un ohmmètre de terre ou telluromètre.

La figure 1 B illustre le principe d'une méthode de mesure de la résistivité du sol (100) par une méthode à 4 points connue sous le nom de méthode de Wenner. Cette méthode utilise également un ohmmètre (130) de terre et 4 piquets (141, 142, 151, 152) alignés placés à des distances et des profondeurs précises. Les deux piquets (141, 142) extérieurs sont reliés au générateur (132) et la mesure de la tension entre les deux piquets (151, 152) de mesure, placés entre les piquets (141, 142) d'injection, permet de déterminer la résistance du circuit ainsi créer et par suite la résistivité du sol (100).

Le document FR 2 726 083 décrit un procédé de contrôle de la protection cathodique d'une conduite enterrée, laquelle conduite fait l'objet d'une protection cathodique par un dispositif à courant imposé ou de soutirage. Ledit procédé de contrôle comprend la mesure de la résistivité du sol le long de ladite conduite au moyen d'un telluromètre.

Dans la suite du document, le terme « résistance de sol » désigne un mesurande permettant de déterminer la résistivité du sol ou la résistance d'un circuit électrique intégrant une portion de sol ou la résistance au sol d'une strcuture enterrée telle que la résistance d'une prise de terre.

Selon l'art antérieur, les principes de mesure exposés ci-avant sont combinés et intègrent, selon certains mode de réalisation, une électrode de référence. Dans tous les cas l'utilisation d'un ohmmètre de terre ou telluromètre est nécessaire. De plus, des distances de plusieurs mètres entre les piquets doivent être respectées ce qui implique de disposer d'une surface de terrain suffisante. L'utilisation d'un ohmmètre de terre entraîne des conséquences sur les conditions de réalisation de la mesure, ainsi parapte exemple, la prise de terre doit pouvoir être isolée de l'installation électrique qu'elle protège lors de cette mesure.

L'invention vise à résoudre les inconvénient de l'art antérieur et concerne à cette fin un dispositif pour la mesure d'une résistance de sol, lequel dispositif consiste en :

> a. une électrode, dite piquet, apte à être insérée dans le sol ;
> b. un moyen de connexion électrique à une structure enterrée, notamment une canalisation ;
> c. un circuit électrique de liaison, d'impédance connue, reliant l'électrode piquet et le moyen de connexion ;
> d. des moyens de commutation aptes à ouvrir et à fermer ledit circuit électrique de liaison ;
> e. un moyen, dit ampèremètre, apte à mesurer le courant dans le circuit électrique de liaison ;
> f. un moyen, dit voltmètre, apte à mesurer la différence de potentiel entre l'électrode et le moyen de connexion électrique
> g. un ensemble d'acquisition et de traitement comprenant des moyens de pilotage des moyens de commutation.

Ainsi le dispositif objet de l'invention n'utilise pas de générateur de courant et n'utilise qu'une seule électrode insérée dans le sol. Ce dispositif est ainsi plus rapide, plus simple et plus sûr de mise en oeuvre et requiert une surface de terrain moins importante du fait de l'électrode piquet unique.

L'invention peut être mise en oeuvre selon les modes de réalisation avantageux exposés ci-après, lesquels peuvent être considérés individuellement ou selon toute combinaison techniquement opérante.

Avantageusement, les moyens de commutation comportent :

di. une position dite fermée, fermant le circuit électrique de liaison en série avec l'ampèremètre ;
dii. une position dite ouverte, ouvrant le circuit électrique de liaison.

Ainsi le dispositif objet de l'invention permet de piloter des mesures dites « enclenché - déclenché » du circuit créé entre la structure enterrée et l'électrode.

Lesdites mesures étant réalisées alors que la différence de potentiel est la même dans les deux cas entre les deux extrémités du circuit électrique de liaison, elle permettent de déterminer l'impédance du circuit.

Avantageusement, l'ensemble d'acquisition et de traitement comporte des moyens de temporisation aptes à cadencer le pilotage des moyens de commutation. Ainsi, le dispositif permet la programmation d'une série de mesure afin de suivre une évolution ou d'améliorer la précision desdites mesures.

Avantageusement, l'ensemble d'acquisition et de traitement comprend des moyens de mémoire et des moyens de calcul aptes à stocker et analyser une série de mesures successives. Ainsi, la précision de mesure est améliorée par le traitement statistique de plusieurs mesures successives.

Avantageusement, l'ensemble d'acquisition et de traitement comporte des moyens de filtrage aptes à extraire une composante spectrale des mesures réalisées par l'ampèremètre et par le voltmètre. Ainsi le dispositif objet de l'invention est particulièrement adapté à la mesure de l'impédance d'une prise de terre.

Avantageusement, l'ensemble d'acquisition et de traitement comporte des moyens de saisie aptes à acquérir des informations contextuelle relatives à la mesure. Ainsi le dispositif objet de l'invention permet, selon ce mode de réalisation, permet de déterminer la résistivité du sol à partir des mesures de résistance.

Selon un mode de réalisation particulier, l'électrode piquet est un dispositif comportant une électrode de référence et un coupon témoin et des moyens, dits de basculement, pour commuter la connexion du circuit électrique de liaison à l'électrode de référence ou au coupon témoin. Ainsi, le dispositif permet de mesurer le potentiel électrochimique de la structure reliée au moyen de connexion électrique.

Avantageusement, l'ensemble d'acquisition et de traitement comporte des moyens pour piloter les moyens de basculement. Ainsi des protocoles de mesure complexes sont réalisables de manière automatique.

L'invention concerne également un procédé pour la mesure d'une résistance de sol au moyen du dispositif objet de l'invention, lequel procédé comporte les étapes consistant à :

i. connecter le moyen de connexion électrique à une structure métallique enterrée ;
ii. insérer l'électrode piquet dans le sol ;
iii. fermer le circuit électrique de liaison et mesurer le courant électrique $I_{fermé}$ parcourant ledit circuit ;

iv. Ouvrir le circuit électrique de liaison et mesurer la différence de potentiel $\Delta V_{ouvert}$ entre le piquet et le moyen connexion électrique ;
v. effectuer le ratio $R' = \Delta V_{ouvert} / I_{fermé}$;
vi. déterminer la résistance de sol à partir du ratio $R$ et de l'impédance du circuit électrique de liaison.

Ainsi, le procédé objet de l'invention permet, à partir de l'insertion d'un seule piquet et d'une séquence de mesure simple d'obtenir rapidement une valeur de la résistance de sol. La simplicité de mise en oeuvre permet de renouveler la mesure en faisant ou non varier les conditions, telles que l'implantation du piquet, la distance par rapport à la structure enterrée, les conditions climatiques, de sorte à obtenir une image fiable et détaillée de la résistance de sol.

Selon un mode de réalisation avantageux, le procédé objet de l'invention comprend les étapes consistant à :

vii. répéter les étapes iii) à vi) et stocker chaque mesure ainsi réalisée dans les moyens de mémoire ;
viii. réaliser un traitement statistique des résultats ainsi obtenus avant l'étape vi).

Ledit traitement statistique permet d'améliorer la précision et la fiabilité des mesures en éliminant, notamment par des techniques de moyennage, des facteurs de variabilité desdites mesures.

Avantageusement, selon ce dernier mode de réalisation, l'étape vii) est réalisée en modifiant le temps séparant les étapes iii) et iv) à chaque répétition et l'étape viii) comprend l'élimination des mesures incohérentes. Ainsi, des effets tels que la présence d'une capacité électrolytique entre l'électrode piquet et le sol et susceptibles de fausser les mesures sont détectés et éliminés.

Selon un mode de réalisation avantageux le procédé objet de l'invention comprend les étapes consistant à :

ix. obtenir une valeur de la résistance au sol de la structure enterrée ;
x. corriger la valeur déterminée à l'étape vi) par la valeur déterminée à l'étape ix.

Ainsi la mesure réalisée et plus précise.

Selon une première variante de ce mode de réalisation du procédé objet de l'invention, l'étape ix) est réalisée par les moyens de saisie. Ce mode de réalisation est le plus simple de mise en oeuvre et nécessite le moins de matériel.

Selon une deuxième variante dudit dernier mode de réalisation du procédé objet de l'invention, l'étape xi) est réalisée en effectuant les étapes iii) à vi) le circuit électrique de liaison étant établi entre le moyen de connexion électrique et l'électrode de référence. Cette variante de réalisation permet une évaluation plus précise de la résistance au sol de la structure enterrée.

Avantageusement, le procédé objet de l'invention comprend une étape consistant à :

xi. calculer la résistivité du sol à partir du résultat de l'étape vi) et de la géométrie de l'électrode piquet.

L'invention est exposée ci-après selon ses modes de réalisation préférés, nullement limitatifs, et en référence aux figures 1 à 3, dans lesquelles :

- la figure 1 relative à l'art antérieur illustre selon une vue en coupe le montage mesure utilisé pour mesurer la résistance au sol d'une prise de terre, figure 1A et la résistivité du sol, figure 1 B ;
- la figure 2 illustre schématiquement selon une vue en coupe similaire à la coupe de la figure 1 un exemple de réalisation du dispositif objet de l'invention et de sa mise en oeuvre ;
- et la figure 3 est un logigramme d'un exemple de réalisation du procédé objet de l'invention.

Figure 2, selon un exemple de réalisation du dispositif (200) objet de l'invention, ledit dispositif comporte un circuit électrique (230) de liaison connectant une électrode (221) dite piquet insérée dans le sol (100). Selon un exemple de réalisation ladite électrode (221) se présente sous la forme d'un piquet métallique ou sous la forme d'un coupon témoin couramment utilisé dans le domaine de la mesure électrochimique. Un tel coupon témoin est de caractéristiques géométriques définies et permet ainsi de déterminer la résistivité du sol. Selon un autre exemple de réalisation, l'électrode (221) piquet est une prise de terre, sous la forme d'un piquet, d'une plaque ou d'un treillis métalliques. D'une manière générale, l'électrode (221) piquet est une structure dont la connaissance de la résistance au sol est recherchée. L'autre extrémité dudit circuit (230) électrique de liaison est connectée, au moyen d'un connecteur (222) électrique, à une structure métallique (210) enterrée de grande dimension, par exemple, une canalisation. Une telle canalisation est toujours disponible en milieu urbain ou à proximité d'installations industrielles. Ladite canalisation (210) fait l'objet ou non d'une protection cathodique. Une différence de potentiel Δ*V* existe entre la canalisation (210) et l'électrode (221) piquet. Cette différence de potentiel est mesurée par un voltmètre (231) connecté en parallèle à chaque extrémité du circuit (230) électrique de liaison. Cette différente de potentiel est générée par la protection cathodique par soutirage de la canalisation, par la polarisation de ladite canalisation dans le milieu électrolytique constituant le sol (100) ou encore par la présence de courants dits vagabonds dans le sol. Des moyens de commutation (240) permettent d'ouvrir ou de fermer le circuit (230) électrique de liaison. Ledit circuit (230) électrique de liaison comporte un ou plusieurs éléments (241) d'impédance connue. Par exemple une résistance (241) ou une capacité (non représentée). Lorsque le circuit (230) électrique de liaison est fermé, le courant circulant dans ledit circuit traverse un ampèremètre (233) qui permet de mesurer l'intensité dudit courant. Selon un exemple de réalisation, le circuit électrique de liaison est purement résistif. Ainsi, lorsque le commutateur (240) ferme le circuit de liaison il s'établit un circuit électrique entre la canalisation (210) et l'électrode (221) piquet. Ce circuit électrique comporte trois résistances en série, la résistance (241) du circuit de liaison de valeur *R1*, la résistance au sol de l'électrode (221) piquet, de valeur *R*, et la résistance au sol de la canalisation (210), de valeur *R2.* Dans ces conditions l'ampèremètre (233) mesure le courant *I* circulant dans ledit circuit et conformément à la loi d'Ohm :
Δ *V=(R+R1+R2).I* pour préciser que cette mesure est obtenue lorsque le circuit est fermé, l'intensité est notée $I_{fermé}$.

Lorsque le commutateur (240) est ouvert, le circuit électrique est ouvert et le courant ne circule plus dans le circuit. Le voltmètre (232) mesure dans ces conditions la différence de potentiel Δ*V*, notée Δ$V_{ouvert}$, entre les deux extrémités du circuit. Ainsi,

$$(R{+}R1{+}R2).I_{fermé} = \Delta V_{ouvert}$$

Et par suite :

$$R = \left( \Delta V_{ouvert} \, / \, I_{fermé} \right) - R1 - R2$$

Connaissant *R1*, il reste à déterminer *R2* pour obtenir la valeur recherchée *R.*

Selon le mode de réalisation la valeur de *R2* est connue ou au moins estimable en fonction de la nature de la canalisation (210), de sa géométrie et de la nature du sol (100). À cette fin, le dispositif (200) objet de l'invention comporte des moyens de saisie (260) connectés à un ensemble (250) d'acquisition et de traitement, sous la forme d'un calculateur comprenant des moyens de mémoire. Les moyens de saisie, permettent ainsi de sélectionner des configurations pré-enregistrées dans les moyens de mémoire dudit calculateur afin d'évaluer *R2*. Alternativement, ou de manière complémentaire, lesdits moyens de saisie (260) comprennent un lecteur de cartes mémoire, lesquelles cartes comportent un enregistrement de données correspondant à une situation de mesure déterminée, données utilisées par le calculateur (250) pour déterminer *R2*. Selon un autre exemple de réalisation l'électrode piquet comprend une l'électrode (225) de référence. À titre d'exemple l'électrode de référence est constituée d'une solution saturée de cuivre et de sulfate de cuivre dans de l'eau distillée, enfermée dans un tube et comportant un embout poreux pour mettre en contact la dite solution avec le milieu constituant le sol. Selon ce mode de réalisation, le dispositif objet de l'invention comprend des moyens (270) de basculement permettant d'établir le circuit électrique de liaison, soit avec l'électrode (221) piquet soit avec l'électrode (225) de référence. Avantageusement les moyens (270) de basculement sont pilotés par le calculateur. La réalisation de séquences de mesure avec l'électrode de référence (225) dont le potentiel est connu, permettent de déterminer la résistance R2. Avantageusement moyens de commutation (240) permettant d'ouvrir ou de fermer le circuit (230) électrique de liaison sont également piloté par le calculateur (250). Ledit calculateur comporte une horloge et offre ainsi la possibilité de cadencer plusieurs mesures circuit - ouvert et circuit - fermé, de même que de contrôler le temps séparant deux mesure. Ainsi, le voltmètre (232) et l'ampèremètre (233) étant reliés au calculateur (250) qui enregistre dans ses moyens de mémoire les mesures issues de ces deux instruments, une série de mesures avec des temps évolutifs séparant la mesure en configuration circuit ouvert et la mesure en configuration circuit fermé est réalisée et les résultats de ces mesures sont stockés dans la mémoire du calculateur (250). Avantageusement le calculateur comprend des algorithmes de traitement de la série de résultat correspondant à des cas théoriques ou déterminés de manière empirique de sorte à ne retenir que les mesures cohérentes et à améliorer la précision desdites mesures, notamment par moyennage.

Les mode de réalisation décrit ci-avant s'applique que la source de tension entre l'électrode (221) piquet et la canalisation (210) soit continue ou alternative. Le dispositif (200) objet de l'invention comprend avantageusement des moyens de filtrage au niveau du calculateur (250) lesquels moyens sont adaptés pour mesurer les impédances spectrales du circuit électrique. Ce mode de réalisation permet d'utiliser les courants vagabonds, présents dans le sol, et d'exploiter lesdits courants comme source de tension dans une bande spectrale autour de 50 Hz, notamment lorsque l'électrode (221) piquet est une prise de terre dont la valeur de la résistance est recherchée.

Dans le cas où la résistivité p du sol est recherchée, l'électrode de référence est avantageusement un coupon témoin, généralement de forme cylindrique de géométrie connue et calibrée. Ainsi la résistivité p du sol est déduit de la résistance au sol R dudit coupon par une formule de type :

$$R = (\rho / 2\pi L). (\ln(4L / r) - 1)$$

où r est le rayon du coupon et L sa longueur, ces caractéristiques étant introduite dans le calculateur (250) par les moyens de saisie. Les résultats des différents traitement sont affichés sur l'afficheur (265) du dispositif objet de l'invention.

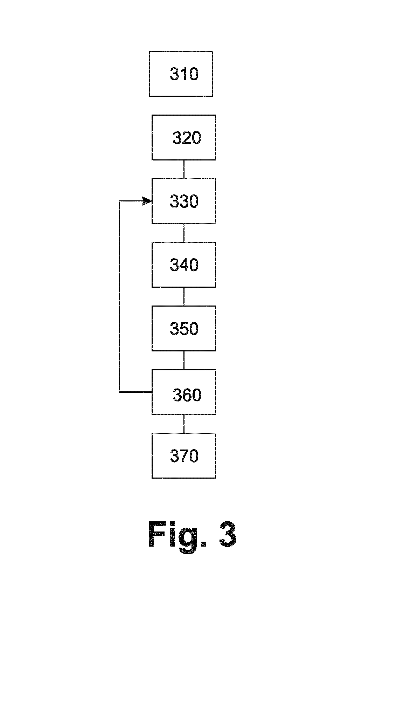

Figure 3, selon une première étape (310) de connexion, le procédé objet de l'invention nécessite la connexion du connecteur électrique à la canalisation suivie d'une étape d'insertion (320) de l'électrode piquet dans le sol. Une étape (330) de fermeture du circuit de liaison permet d'obtenir la valeur de $I_{fermé}$. Une étape suivante (340) d'ouverture du circuit permet d'obtenir la valeur $\Delta V_{ouvert}$. Une première étape de traitement (350) permet d'obtenir la valeur $R'=\Delta V_{ouvert}/I_{fermé}$ laquelle valeur est utilisée dans une étape (360) de calcul pour déterminer la résistance R selon les diverses variantes décrites ci-avant. L'ensemble des étapes depuis l'étape (330) de fermeture, jusqu'à l'étape de calcul sont avantageusement répétée, les résultats correspondant étant stockés dans la mémoire du calculateur. Une étape (370) de traitement statistique permet de compiler ces résultats et d'en améliorer la précision.

La description ci-avant et les exemples de réalisation montrent que l'invention atteint les objectifs visés, en particulier la combinaison du dispositif et du procédé objets de l'invention permettent de réaliser facilement des mesures de résistance du sol, et de disposer d'un matériel de mesure transportable pouvant être mis en oeuvre par une personne seule, sans danger pour les installations et les personnes circulant à proximité de celles-ci du fait de l'absence de générateur de courant.

**Revendications**

1. Dispositif (200) pour la mesure d'une résistance de sol (100), lequel dispositif consiste en :

   a. une électrode (221), dite piquet, apte à être insérée dans le sol ;
   b. un moyen (222) de connexion électrique à une structure (210) enterrée, notamment une canalisation ;
   c. un circuit (230) électrique de liaison, d'impédance (241) connue, reliant l'électrode (221) piquet et le moyen (222) de connexion ;
   d. des moyens (240) de commutation aptes à ouvrir et à fermer ledit circuit (230) électrique de liaison ;
   e. un moyen (233), dit ampèremètre, apte à mesurer le courant dans le circuit électrique de liaison ;
   f. un moyen (232), dit voltmètre, apte à mesurer la différence de potentiel entre l'électrode (221) piquet et le moyen (222) de connexion électrique
   g. un ensemble (250) d'acquisition et de traitement comprenant des moyens de pilotage des moyens (240) de commutation.

2. Dispositif selon la revendication 1, dans lequel les moyens (240) de commutation comportent :

   di. une position dite fermée, fermant le circuit (230) électrique de liaison en série avec l'ampèremètre (233) ;
   dii. une position dite ouverte, ouvrant le circuit (230) électrique de liaison.

3. Dispositif selon la revendication 1, dans lequel l'ensemble (250) d'acquisition et de traitement comporte des moyens de temporisation aptes à cadencer le pilotage des moyens (240) de commutation.

4. Dispositif selon la revendication 1, dans lequel l'ensemble (250) d'acquisition et de traitement comprend des moyens de mémoire et des moyens de calcul aptes à stocker et analyser une série de mesures successives.

5. Dispositif selon la revendication 1, dans lequel l'ensemble (250) d'acquisition et de traitement comporte des moyens de filtrage aptes à extraire une composante spectrale des mesures réalisées par l'ampèremètre (233) et par le voltmètre (232).

6. Dispositif selon la revendication 1, dans lequel l'ensemble (250) d'acquisition et de traitement comporte des moyens (260) de saisie aptes à acquérir des informations contextuelle relatives à la mesure.

7. Dispositif selon la revendication 1, dans lequel l'électrode piquet est un dispositif comportant une électrode (225) de référence et un coupon (221) témoin et des moyens (270), dits de basculement, pour commuter la connexion du circuit (230) électrique de liaison à l'électrode (225) de référence ou au coupon (221) témoin.

8. Dispositif selon la revendication 7, dans lequel l'ensemble (250) d'acquisition et de traitement comporte des moyens pour piloter les moyens de basculement.

9. Procédé pour la mesure d'une résistance de sol au moyen d'un dispositif selon la revendication 1, **caractérisé en ce qu'il** comporte les étapes consistant à :

    i. connecter (310) le moyen (222) de connexion électrique à une structure (210) métallique enterrée ;
    ii. insérer (320) l'électrode (221) piquet dans le sol (100) ;
    iii. fermer (330) le circuit (230) électrique de liaison et mesurer le courant électrique $I_{fermé}$ parcourant ledit circuit
    iv. ouvrir (340) le circuit (230) électrique de liaison et mesurer la différence de potentiel $\Delta V_{ouvert}$ entre le piquet (221) et le moyen (222) connexion électrique
    v. effectuer (350) le ratio $R' = \Delta V_{ouvert} / I_{fermé}$
    vi. déterminer (360) la résistance de sol à partir du ratio $R'$ et de l'impédance du circuit électrique de liaison.

10. Procédé selon la revendication 9, mis en oeuvre par un dispositif selon les revendications 3 et 4, **caractérisé en ce qu'il** comporte les étapes consistant à :

    vii. répéter les étapes iii) à vi) et stocker chaque mesure ainsi réalisée dans les moyens de mémoire ;
    viii. réaliser (370) un traitement statistique des résultats ainsi obtenus avant l'étape vi) ;

11. Procédé selon la revendication 10, dans lequel l'étape vii) est réalisée en modifiant le temps séparant les étapes iii) et iv) à chaque répétition et l'étape viii) comprend l'élimination des mesures incohérentes.

12. Procédé selon la revendication 9, utilisant un dispositif selon la revendication 6 ou la revendication 7, **caractérisé en ce qu'il** comprend les étapes consistant à :

    ix. obtenir une valeur de la résistance au sol de la structure enterrée ;
    x. corriger la valeur déterminée à l'étape vi) par la valeur déterminée à l'étape ix.

13. Procédé selon la revendication 12, dans lequel l'étape ix) est réalisée par les moyens (260) de saisie.

14. Procédé selon la revendication 12, dans lequel l'étape xi) est réalisée en effectuant les étapes iii) à vi) le circuit électrique de liaison étant établi entre le moyen (222) de connexion électrique et l'électrode (225) de référence.

15. Procédé selon la revendication 9, **caractérisé en ce qu'il** comprend une étape consistant à :

    xi. calculer la résistivité du sol à partir du résultat de l'étape vi) et de la géométrie de l'électrode (221) piquet.

**1A**

**1B**

# Fig. 1
(art antérieur)

# Fig. 2

310

320

330

340

350

360

370

# Fig. 3

Europäisches
Patentamt

European
Patent Office

Office européen
des brevets

## RAPPORT DE RECHERCHE EUROPEENNE

Numéro de la demande

EP 12 30 6502

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 0 435 761 A1 (GAZ DE FRANCE [FR]) 3 juillet 1991 (1991-07-03) * le document en entier * ----- | 1-15 | INV.<br>G01N27/04<br>G01R27/20<br>G01N33/24 |
| X | US 6 107 811 A (CAUDILL DAN L [US] ET AL) 22 août 2000 (2000-08-22) * abrégé; figures 1,2 * * colonne 1, ligne 32 - colonne 2, ligne 15 * * colonne 2, ligne 38 - ligne 67 * * colonne 3, ligne 34 - colonne 5, ligne 39 * ----- | 1-15 | |
| X | US 5 469 048 A (DONOHUE CHARLES W [US]) 21 novembre 1995 (1995-11-21) * abrégé; figures 1,2 * ----- | 1-15 | |

| DOMAINES TECHNIQUES RECHERCHES (IPC) |
|---|
| G01R<br>G01N<br>G01V |

Le présent rapport a été établi pour toutes les revendications

| Lieu de la recherche | Date d'achèvement de la recherche | Examinateur |
|---|---|---|
| Berlin | 18 avril 2013 | Binger, Bernard |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 12 30 6502

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

18-04-2013

| Document brevet cité au rapport de recherche | | Date de publication | Membre(s) de la famille de brevet(s) | | Date de publication |
|---|---|---|---|---|---|
| EP 0435761 | A1 | 03-07-1991 | CA | 2033218 A1 | 28-06-1991 |
| | | | DE | 69007763 D1 | 05-05-1994 |
| | | | DE | 69007763 T2 | 04-08-1994 |
| | | | EP | 0435761 A1 | 03-07-1991 |
| | | | FR | 2656426 A1 | 28-06-1991 |
| | | | US | 5144253 A | 01-09-1992 |
| US 6107811 | A | 22-08-2000 | CA | 2258360 A1 | 12-08-1999 |
| | | | US | 6107811 A | 22-08-2000 |
| US 5469048 | A | 21-11-1995 | AUCUN | | |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2726083